# EUROPÄISCHE PATENTSCHRIFT

(11) **EP 1 190 612 B1**
(45) Veröffentlichungstag und Bekanntmachung des Hinweises auf die Patenterteilung: **27.11.2002**
(21) Anmeldenummer: 00952901.7
(22) Anmeldetag: 04.07.2000
(51) Int. Cl.: H05K 13/08, H04B 10/00

(54) **VERFAHREN UND VORRICHTUNG ZUR DATENÜBERTRAGUNG ZWISCHEN EINEM BESTÜCKAUTOMATEN UND EINER ZUFÜHREINHEIT, BESTÜCKAUTOMAT UND ZUFÜHREINHEIT**
METHOD AND DEVICE FOR TRANSMITTING DATA BETWEEN PICK-AND-PLACE ROBOTS AND A FEEDING UNIT, PICK-AND-PLACE ROBOT AND FEEDING UNIT
PROCEDE ET DISPOSITIF POUR TRANSFERT DE DONNEES ENTRE UN AUTOMATE D'EQUIPEMENT ET UNE UNITE D'AMENEE, AUTOMATE D'EQUIPEMENT ET UNITE D'AMENEE Y RELATIFS

(30) Priorität: 06.07.1999 DE 19931054
(43) Veröffentlichungstag der Anmeldung: 27.03.2002
(73) Patentinhaber: SIEMENS AKTIENGESELLSCHAFT, 80333 München (DE)
(72) Erfinder: ESCHENWECK, Friedrich, D-85622 Feldkirchen (DE)
(86) Internationale Anmeldenummer: DE0002177
(87) Internationale Veröffentlichungsnummer: WO01003489

(56) Entgegenhaltungen:
- EP-A- 0 794 624
- EP-A- 0 859 543

## Beschreibung

Verfahren und Vorrichtung zur Datenübertragung zwischen einem Bestückautomaten und einer Zuführeinheit, Bestückautomat und Zuführeinheit

Die Erfindung bezieht sich auf ein Verfahren zur Datenübertragung zwischen einem Bestückautomaten und einer Zuführeinheit sowie eine Vorrichtung zur Datenübertragung zwischen einem Bestückautomaten und mindestens einer Zuführeinheit gemäß dem Oberbegriff des Patentanspruchs 5 sowie eine Zuführeinheit für einen Bestückautomaten gemäß dem Oberbegriff des Patentanspruchs 7 und einen Bestückautomaten.

EP-A-0 859 543 offenbart einen Bestückautomaten, der mit einer angekoppelten Zuführeinheit für Bauelemente über eine drahtgebundene Verbindung mit Steckkontakt Daten austauschit sowie ein entsprechen des Verfahren zur Datenübertragung.

In einem Bestückautomaten werden Bauelemente aus Zuführeinheiten mit Hilfe einer Haltevorrichtung entnommen, mittels der Haltevorrichtung an eine vorgegebene Position oberhalb eines Substrats bewegt und dort abgesetzt. Für unterschiedliche Bauelementtypen sind dabei unterschiedliche Zuführeinheiten vorgesehen. Die Zuführeinheiten mit den Bauelementen werden dabei in einer vorgegebenen Position an den Bestückautomaten gestellt, so daß die Haltevorrichtung des Bestückautomaten die Bauelemente aus den Zuführeinheiten entnehmen kann. Die Ansteuerung der Zuführeinheiten, beispielsweise von sog. "Tape-Feedern", erfolgt über eine drahtgebundene Verbindung zwischen der Steuereinrichtung des Bestückautomaten und der Steuereinrichtung der Zuführeinheit. Sobald ein Bauelement von der Haltevorrichtung abgeholt wurde, gibt die Steuereinrichtung des Bestückautomaten an die Steuereinrichtung der Zuführeinheit den Befehl, den mit Bauelementen gefüllten Gurt eine Position weiter zu transportieren. Um einen möglichst schnellen Wechsel der Zuführeinheiten zu gewährleisten, sind für diese drahtgebundenen Verbindungen Stecker in einem festen Raster am Bestückautomaten vorgesehen. Die Breite der Zuführeinheiten hat sich nach diesem Raster zu richten, wodurch vor allem bei neuen, kleineren Bauelementen, eine Erhöhung der Bauelementvielfalt am Bestückautomaten, die eigentlich durch die kleinere Dimension der Bauelemente möglich wäre, verhindert wird.

Es ist daher die Aufgabe der Erfindung, ein Verfahren und eine Vorrichtung anzugeben, mit der ein möglichst rasterfreies Stellen von Zuführeinheiten an einen Bestückautomaten gewährleistet wird.

Die Aufgabe wird erfindungsgemäß gelöst durch ein Verfahren und eine Vorrichtung der eingangs genannten Art mit den kennzeichnenden Merkmalen der Patentansprüche 1 bzw. 5 sowie eine Zuführeinheit mit den Merkmalen des Anspruchs 7 und einen Bestückautomaten mit den Merkmalen des Anspruchs 8.

Durch die Datenübertragung auf optischem Wege zwischen Bestückautomat und Zuführeinheit ist es möglich, daß die den Zuführeinheiten zugeordneten optischen Sender und Empfänger an beliebiger Position des Lichtwellenleiters angeordnet werden können. Durch diesen Verzicht auf das feste Raster ist sichergestellt, daß zukünftige veränderte Bauteildimensionen flexibel am Bestückautomaten berücksichtigt werden.

In vorteilhafter Weise wird gemäß Anspruch 2 vorgesehen, daß mehrere Zuführeinheiten an einen Lichtwellenleiter ankoppelbar sind. Dadurch ergibt sich ein besonders flexibler Aufbau der Zuführeinheiten am Bestückautomaten.

Besonders einfach gestaltet sich das Verfahren dadurch, daß gemäß Anspruch 3 die Sender ihre Daten gleichzeitig an alle Empfänger übermitteln.

Für die gleichzeitige Übermittlung der Daten aller Empfänger eignet sich besonders das aus der Automobilbranche bekannte CAN(Controller Area Network)-Verfahren gemäß Anspruch 4.

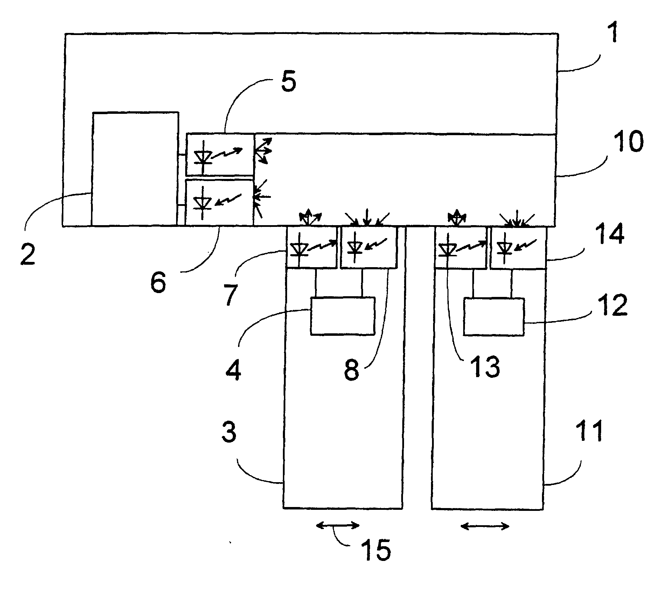

Anhand der einzigen Figur der Zeichnung wird die Erfindung mittels eines Ausführungsbeispiels näher erläutert.

Die Figur zeigt dabei eine schematische Ansicht eines Bestückautomaten mit angekoppelten Zuführeinheiten. Dabei ist schematisch ein Bestückautomat 1 mit einer ersten Steuereinrichtung 2 dargestellt, an den eine erste Zuführeinheit 3 mit einer zweiten Steuereinrichtung 4 angekoppelt ist. Die Zuführeinheit 3 dient dazu, Bauelemente eines Bauelementtyps zur Verfügung zu stellen, die von einer nicht dargestellten Haltevorrichtung des Bestückautomaten 1 auf ebenfalls nicht dargestellte Substrate in einer vorgegebenen Position abgesetzt werden. Die zweite Steuereinrichtung 4 dient dazu, nach dem Abholen eines Bauelements aus der Zuführeinheit 3 weitere Bauelemente zur Verfügung zu stellen. Bei einem sog. "Tape-Feeder wird beispielsweise ein Gurt, in dem sich Taschen mit Bauelementen befinden, eine Position weitergetaktet. Bei einer weiteren bekannten Zuführeinheit, einem sog. "Waffle-Pack-Wechsler", dient die zweite Steuereinrichtung 4 dazu, die sog. Trays auszuwechseln. Unter einem Tray wird dabei eine waagerecht angeordnete Fläche verstanden, auf der mehrere Bauelemente nebeneinander flächig angeordnet sind. Die Kommunikation zwischen der ersten Steuereinrichtung 2 des Bestückautomaten 1 und der zweiten Steuereinrichtung 4 der Zuführeinheit 3 wurde bisher drahtgebunden abgewickelt. Erfindungsgemäß sind der ersten Steuereinrichtung 2 ein erster optischer Sender 5 und ein erster optischer Empfänger 6 zugeordnet und mit ihr verbunden, die mit einem zweiten optischen Sender 7 und einem zweiten optischen Empfänger 8, die mit der zweiten Steuereinrichtung 4 verbunden sind, kommunizieren.

Die Kommunikation erfolgt dabei über einen den Bestückautomaten 1 zugeordneten Lichtwellenleiter 10, in den die optischen Sender die zu übertragenden Daten einkoppeln, und die optischen Empfänger 6, 8 die Daten empfangen. Der Lichtwellenleiter 10 kann dabei beispielsweise als Schichtwellenleiter ausgebildet sein, an dessen Seitenflächen die Sender 5,7 und Empfänger 6,8 angeordnet sind. Entsprechend erfolgt auch die Kommunikation mit einer weiteren Zuführeinheit 11, die eine weitere Steuereinrichtung 12 und mit dieser verbunden einen weiteren optischen Sender 13 und einen weiteren optischen Empfänger 14 umfaßt. Durch die Nutzung eines Lichtwellenleiters 10 lassen sich die beiden Zuführeinheiten 3,11 entlang der Verschieberichtung 15 beliebig positionieren. Dadurch können die Zuführeinheiten 3,11 rasterfrei an den Bestückautomaten 1 angekoppelt werden. Dadurch lassen sich beliebig breite Zuführeinheiten 3, 11 realisieren und an einen Bestückautomaten 1 ankoppeln.

Die Übertragung der Daten kann dabei von einem der Sender 5,7,13 an alle Empfänger 6,8,14 gleichzeitig erfolgen. Ein solches Verfahren ist beispielsweise aus der Automobilbranche als CAN(Controller Area Network)-Verfahren bekannt. Die maximale Übertragungsrate ist dabei mit 1 Megabit/Sekunde definiert. Das Zugriffsverfahren von CAN wird durch CSMA/CA am besten beschrieben. CSMA/CA steht für Carrier Sense Multiple Access with Collision Avoidance. Der Unterschied zum bekannten CSMA/CD (with Collision Detection) ist, daß bei einer Kollision ein Teilnehmer die Sendeberichtigung erhält, während sich bei CSMA/CD alle Teilnehmer vom Bus zurückziehen und erst später einen erneuten Zugriff versuchen. CAN ist mit diesem Verfahren multimasterfähig. Das heißt, daß mehrere Sender den Bus gleichzeitig anfordern können. Kommt es dabei zu einer Kollision, weil verschiedene Sender den Bus gleichzeitig arbitrieren (anfordern), erhält der Sender mit der höheren Priorität den Buszugriff.

Damit dieses Zugriffsverfahren realisiert werden kann, müssen folgende Grundvoraussetzungen gelten:
- Alle Teilnehmer arbeiten nach dem Listen While Talk-Prinzip. Daß heißt, daß sie die Leitung ständig abhören, auch während sie schreiben.
- Schreiben mehrere Teilnehmer gleichzeitig, ist auf dem Bus eine logische Null, auch wenn nur einer der Teilnehmer eine Null schreibt.
- Jeder Teilnehmer muß eine eigene eindeutige Identifizierung haben. Diese wird gleichzeitig als Priorität verwendet (je kleiner die Identifizierung, desto größer die Priorität).

Ist der Bus frei, kann ein Teilnehmer den Bus anfordern, indem er ein Startbit auf den Bus schreibt. Danach fängt er an, Bit für Bit seine Identifizierung und damit seine Priorität auf den Bus zu schreiben. Die anderen Teilnehmer synchronisieren sich mit dem Startbit. Möchte noch ein Teilnehmer den Bus anfordern, schreibt auch er seine Identifizierung und damit seine Priorität synchron zu dem ersten Teilnehmer auf den Bus. Erkennt ein Teilnehmer beim Schreiben einer Eins, daß der vom Bus zurückgelesene Wert Null ist, hat er daraus zu folgern, daß ein anderer Teilnehmer höherer Priorität ihn überschrieben hat. Er darf dann keine weiteren schreibenden Buszugriffe machen. Er muß vielmehr warten, bis das Telegramm beendet ist (erkennbar durch ein EOF-Byte (End of Frame)). Erst dann kann er erneut versuchen, den Bus zu arbitrieren.

Bei der optischen Realisierung des CAN-Verfahrens ist das Licht im Zustand Null immer an und übertrifft daher den rezessiven Pegel (Licht aus) immer.

## Patentansprüche

1. Verfahren zur Datenübertragung zwischen mindestens einer ersten Steuereinrichtung (2), die einem Bestückautomaten (1) zugeordnet ist, und einer zweiten Steuereinrichtung (4), die einer Zuführeinheit (3) für den Bestückautomaten (1) zugeordnet ist, bei dem
- zu sendende Daten elektrisch von der sendenden Steuereinrichtung (2,4) an einen der sendenden Steuereinrichtung zugeordneten optischen Sender (5,7) übertragen werden,
- der optische Sender (5,7) die Daten in einen Lichtwellenleiter (10) einkoppelt,
- ein der empfangenden Steuereinrichtung zugeordneter optischer Empfänger (6,8) die Daten aus dem Lichtwellenleiter (10) empfängt und an die empfangende Steuereinrichtung (2,4) überträgt, wobei Sender und Empfänger der Zuführeinheit beim Ankoppeln der Zuführeinheit an den Bestückautomaten in der Verschieberichtung entlang der lichtwellenleiters rasterfrei positionierbar sind.

2. Verfahren zur Datenübertragung nach Anspruch 1,
**dadurch gekennzeichnet,**
**daß** mindestens eine weitere Zuführeinheit (11) mit einer weiteren Steuereinrichtung (12), einem weiteren optischen Sender (13) und einem weiteren optischen Empfänger (14), die mit der weiteren Steuereinrichtung (12) verbunden sind, vorgesehen sind und
**daß** der weitere optische Sender (13) seine Signale in den Lichtwellenleiter (10) einkoppelt und der weitere optische Empfänger (14) Signale aus dem Lichtwellenleiter (10) empfängt.

3. Verfahren zur Datenübertragung nach einem der Ansprüche 1 oder 2,
**dadurch gekennzeichnet,**
**daß** jeder optische Sender (5,7,13) seine Signale gleichzeitig an alle Empfänger (6,8,14) übermittelt.

4. Verfahren zur Datenübertragung nach Anspruch 3,
**dadurch gekennzeichnet,**
**daß** für die Datenübertragung das CAN (Controller Area Network)- Verfahren verwendet wird.

5. Vorrichtung zur Datenübertragung zwischen einem Bestückautomaten (1) und mindestens einer Zuführeinheit (3) mit einer ersten Steuereinrichtung (2) , die dem Bestückautomaten (1) zugeordnet ist,
mit einer zweiten Steuereinrichtung (4), die der mindestens einen Zuführeinheit (3) zugeordnet ist,
**dadurch gekennzeichnet,**
**daß** die erste Steuereinrichtung (2) mit einem ersten optischen Sender (5) und einem ersten optischen Empfänger (6) verbunden ist,
**daß** die zweite Steuereinrichtung (4) mit einem zweiten optischen Sender (7) und einem zweiten optischen Empfänger (8) verbunden ist
**daß** die optischen Empfänger (6,8) und die optischen Sender (5,7) über einen Lichtwellenleiter (10) miteinander verbunden sind und
**daß** Sender und Empfänger der Zuführeinheit beim Ankoppeln der Zuführeinheit an den Bestückautomaten in der Verschieberichtung (15) entlang des lichtwellenleiters rasterfrei positionierbar sind.

6. Vorrichtung zur Datenübertragung nach Anspruch 5,
**dadurch gekennzeichnet,**
**daß** eine weitere Zuführeinheit (11) vorgesehen ist, die eine weitere Steuereinrichtung (12) und damit verbunden einen weiteren optischen Sender (13) und einen weiteren optischen Empfänger (14) aufweist und
**daß** der weitere optische Sender (13) und der weitere optische Empfänger (14) über den Lichtwellenleiter (10) mit den ersten und zweiten optischen Sendern (5,7) und Empfängern (6,8) verbunden sind.

7. Zuführeinheit (3,11) für einen Bestückautomaten (1) mit einer zweiten Steuereinrichtung (4),
**dadurch gekennzeichnet,**
**daß** die Zuführeinheit (2,11) einen optischen Sender (7,13) und einen optischen Empfänger (8,14) aufweist, die mit der Steuereinrichtung (4,12) verbunden sind und
**daß** der optische Sender (7,13) und der optische Empfänger (8,14) so angeordnet sind, daß diese an einem am Bestückautomaten (1) angeordneten Lichtwellenleiter (10) in der Verschieberichtung (15) entlang des Lichtwellenleiters rasterfrei positionierbar ankoppelbar sind.

8. Bestückautomat (1) mit einer Steuereinrichtung (2), mit einem optischen Sender (5) und einem optischen Empfänger (6), die mit der Steuereinrichtung (2) verbunden sind und mit einem Lichtwellenleiter (10), in den der optische Sender (5) seine Signale sendet und aus dem der optische Empfänger (6) Signale empfängt, wobei der Lichtwellenleiter (10) so angeordnet ist, daß weitere optische Sender (7,13) und optische Empfänger (8,14) von mindestens einer Zuführeinheit (3,11) so ankoppelbar sind, daß sie in der Verschieberichtung (15) entlang des Lichtwellenleiters rasterfrei positionierbar sind.

9. Bestückautomat (1) nach Anspruch 8,
**dadurch gekennzeichnet,**
**daß** der Lichtwellenleiter (10) so angeordnet ist, daß optische Sender (7,13) und optische Empfänger (8,14) von mehreren Zuführeinheiten (3,11) rasterfrei ankoppelbar sind.

## Claims

1. Method for transmitting data between at least one first control device (2), which is assigned to a pick-and-place machine (1), and a second control device (4), which is assigned to a feeding unit (3) for the pick-and-place machine (1), in which
- data to be sent are transmitted electrically from the sending control device (2, 4) to an optical transmitter (5, 7) assigned to the sending control device,
- the optical transmitter (5, 7) launches the data into an optical waveguide (10),
- an optical receiver (6, 8), assigned to the receiving control device, receives the data from the optical waveguide (10) and transmits it to the receiving control device (2, 4), it being possible for the transmitter and receiver of the feeding unit, when the feeding unit is coupled to the pick-and-place machine, to be positioned without any grid pattern along the optical waveguide in the direction of displacement.

2. Method for transmitting data according to Claim 1, **characterized in that** at least one further feeding unit (11) with a further control device (12), a further optical transmitter (13) and a further optical receiver (14), which are connected to the further control device (12), are provided and **in that** the further optical transmitter (13) launches its signals into the optical waveguide (10) and the further optical receiver (14) receives signals from the optical waveguide (10).

3. Method for transmitting data according to one of Claims 1 or 2, **characterized in that** each optical transmitter (5, 7, 13) transmits its signals simultaneously to all the receivers (6, 8, 14).

4. Method for transmitting data according to Claim 3, **characterized in that** the CAN (Controller Area Network) method is used for the data transmission.

5. Device for transmitting data between a pick-and-place machine (1) and at least one feeding unit (3) with a first control device (2), which is assigned to the pick-and-place machine (1), with a second control device (4), which is assigned to the at least one feeding unit (3), **characterized in that** the first control device (2) is connected to a first optical transmitter (5) and a first optical receiver (6), **in that** the second control device (4) is connected to a second optical transmitter (7) and a second optical receiver (8) **in that** the optical receivers (6, 8) and the optical transmitters (5, 7) are connected to one another via an optical waveguide (10), and **in that** the transmitter and receiver of the feeding unit, when the feeding unit is coupled to the pick-and-place machine, can be positioned without any grid pattern along the optical waveguide in the direction of displacement (15).

6. Device for transmitting data according to Claim 5, **characterized in that** a further feeding unit (11) is provided, which has a further control device (10) and, connected to it, a further optical transmitter (13) and a further optical receiver (14) and **in that** the further optical transmitter (13) and the further optical receiver (14) are connected via the optical waveguide (10) to the first and second optical transmitters (5, 7) and receivers (6, 8).

7. Feeding unit (3, 11) for a pick-and-place machine (1) with a second control device (4), **characterized in that** the feeding unit (2, 11) has an optical transmitter (7, 13) and an optical receiver (8, 14), which are connected to the control device (4, 12) and **in that** the optical transmitter (7, 13) and the optical receiver (8, 14) are arranged in such a way that they can be coupled onto an optical waveguide (10) arranged on the pick-and-place machine (1) in such a way that they can be positioned without any grid pattern along the optical waveguide in the direction of displacement (15).

8. Pick-and-place machine (1) with a control device (2), with an optical transmitter (5) and an optical receiver (6), which are connected to the control device (2), and with an optical waveguide (10), into which the optical transmitter (5) sends its signals and from which the optical receiver (6) receives signals, the optical waveguide (10) being arranged in such a way that further optical transmitters (7, 13) and optical receivers (8, 14) of at least one feeding unit (3, 11) can be coupled on in such a way that they can be positioned without any grid pattern along the optical waveguide in the direction of displacement (15).

9. Pick-and-place machine (1) according to Claim 8, **characterized in that** the optical waveguide (10) is arranged in such a way that optical transmitters (7, 13) and optical receivers (8, 14) of a plurality of feeding units (3, 11) can be coupled on without any grid pattern.

## Revendications

1. Procédé pour transfert de données entre au moins un premier élément de commande (2) affecté à un automate d'équipement (1) et un deuxième élément de commande (4) affecté à une unité d'amenée (3) dudit automate d'équipement (1), dans lequel
- des données à émettre sont transférées électriquement par l'élément de commande émetteur (2, 4) à un émetteur optique (5, 7) affecté audit élément de commande émetteur,
- l'émetteur optique (5, 7) injecte les données dans une fibre optique (10) et
- un récepteur optique (6, 8) affecté à l'élément de commande récepteur reçoit les données de la fibre optique (10) et les transfère à l'élément de commande récepteur, l'émetteur et le récepteur de l'unité d'amenée pouvant être positionnés sans grille le long de la fibre optique et dans le sens du déplacement lors de l'accouplage de l'unité d'amenée à l'automate d'équipement.

2. Procédé pour transfert de données selon la revendication 1, **caractérisé en ce qu'**est prévue au moins une unité d'amenée supplémentaire (11) comprenant un élément de commande supplémentaire (12), un émetteur optique supplémentaire (13) et un récepteur optique supplémentaire (14) connectés à l'élément de commande supplémentaire (12) et **en ce que** l'émetteur optique supplémentaire (13) injecte ses signaux dans la fibre optique (10) et le récepteur optique supplémentaire (14) reçoit des signaux de ladite fibre optique (10).

3. Procédé pour transfert de données selon l'une des revendications 1 ou 2, **caractérisé en ce que** chaque émetteur optique (5, 7, 13) transmet simultanément ses signaux à tous les récepteurs (6, 8, 14).

4. Procédé pour transfert de données selon la revendication 3, **caractérisé en ce que** le transfert de données se fait à l'aide du procédé CAN (« Controller Area Network »).

5. Dispositif pour transfert de données entre un automate d'équipement (1) et au moins une unité d'amenée (3), comprenant un premier élément de commande (2) affecté audit automate d'équipement (1) et un deuxième élément de commande (4) affecté à l'au moins une unité d'amenée (3), **caractérisé en ce que** le premier élément de commande (2) est connecté à un premier émetteur optique (5) et à un premier récepteur optique (6), **en ce que** le deuxième élément de commande (4) est connecté à un deuxième émetteur optique (7) et à un deuxième récepteur optique (8), **en ce que** les récepteurs optiques (6, 8) et les émetteurs optiques (5, 7) sont connectés l'un à l'autre par l'intermédiaire d'une fibre optique (10) et **en ce que** l'émetteur et le récepteur de l'unité d'amenée peuvent être positionnés sans grille le long de la fibre optique et dans le sens du déplacement (15) lors de l'accouplage de l'unité d'amenée à l'automate d'équipement.

6. Dispositif pour transfert de données selon la revendication 5, **caractérisé en ce qu'**une unité d'amenée supplémentaire (11) est prévue, laquelle présente un élément de commande supplémentaire (12) auquel sont connectés un émetteur optique supplémentaire (13) et un récepteur optique supplémentaire (14) et **en ce que** l'émetteur optique supplémentaire (13) et le récepteur optique supplémentaire (14) sont connectés avec les premiers et les deuxièmes émetteurs (5, 7) et récepteurs (6, 8) optiques par l'intermédiaire de la fibre optique (10).

7. Unité d'amenée (3, 11) pour un automate d'équipement (1), comprenant un deuxième élément de commande (4), **caractérisée en ce que** l'unité d'amenée (2, 11) présente un émetteur optique (7, 13) et un récepteur optique (8, 14) connectés à l'élément de commande (4, 12) et **en ce que** l'émetteur optique (7, 13) et le récepteur optique (8, 14) sont placés de manière à pouvoir être accouplés à une fibre optique (10) située au niveau de l'automate d'équipement (1) et à pouvoir être positionnés sans grille le long de ladite fibre optique dans le sens du déplacement (15).

8. Automate d'équipement (1) comprenant un élément de commande (2) ainsi qu'un émetteur optique (5) et un récepteur optique (6) connectés audit élément de commande (2) et une fibre optique (10) dans laquelle l'émetteur optique (5) injecte ses signaux et de laquelle le récepteur optique (6) reçoit des signaux, la fibre optique (10) étant placée de manière telle que d'autres émetteurs optiques (7, 13) et récepteurs optiques (8, 14) d'au moins une unité d'amenée (3, 11) peuvent être accouplés de manière telle qu'ils peuvent être positionnés sans grille le long de la fibre optique dans le sens du déplacement (15).

9. Automate d'équipement (1) selon la revendication 8, **caractérisé en ce que** la fibre optique (10) est placée de manière telle que des émetteurs optiques (7, 13) et des récepteurs optiques (8, 14) de plusieurs unités d'amenée (3, 11) peuvent être accouplés sans grille.
